(19) Europäisches Patentamt
European Patent Office
Office européen des brevets

(11) EP 2 285 004 A1

(12) **EUROPEAN PATENT APPLICATION**

(43) Date of publication:
**16.02.2011 Bulletin 2011/07**

(51) Int Cl.:
**H03M 13/11** (2006.01)

(21) Application number: **09165350.1**

(22) Date of filing: **13.07.2009**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(71) Applicant: **Nokia Siemens Networks Oy 02610 Espoo (FI)**

(72) Inventor: **Cannalire, Giacomo Francesco 20062 Cassano d'Adda (IT)**

(74) Representative: **Fischer, Michael Nokia Siemens Networks GmbH & Co. KG COO RTP IPR, Patent Administration 80240 München (DE)**

(54) **Method for pseudo-puncturing exponent matrixes of LDPC codes to comply with different code-rates**

(57) Pseudo-puncturing exponent matrixes of Low Density Parity Check (LDPC) block codes, to meet with increasing code-rates, could be used in networks compliant with fixed and mobile Broadband Wireless Access Networks of standard IEEE 802.16e (WiMAX). Puncturing is performed starting from a base model (mother) exponent table sized $(r_b, n_b)$ that structures the longest codeword $n_0$ divided by the highest spreading factor $Z_0$' thus giving rise to the lowest code-rate $R_0$. The mother exponent table is built according to semi-random techniques, as for example the one shown in IEEE 802.16e (encoding Method 2). For puncturing purpose, a variable positive integer $x$ is set such that the minimum number of rows $r_x = r_b - x$ of the mother exponent table, corresponding to the higher code-rate $R_{x\text{-max}}$, is greater than or equal to the average column weight to have an LDPC code with good performances. Sub-tables for generic code-rates $R_x$ are obtained by deleting from the mother exponent table the $x$ columns and the $x$ rows of the highest indexes. Before deleting, the first column vector of the deterministic part of the mother exponent table shall be adapted to be compliant with the standard requirements of each code-rate $R_x$. The final pseudo-punctured matrix for a code-rate $R_x$ is obtained by masking the relevant expanded sub-table with a specific seed matrix.

| r\c | 1 | 2 | 3 | i | 72 | 73 | 74 | 75 | 76 | 77 | 78 | 79 | i | 87 | 88 | 89 | 90 | 91 | 92 | 93 | 94 | 95 | 96 |
|---|---|---|---|---|---|---|---|---|---|---|---|---|---|---|---|---|---|---|---|---|---|---|
| 1 | 33 | 36 | 39 | | 28 | 31 | 0 | -1 | -1 | -1 | -1 | -1 | | -1 | -1 | -1 | -1 | -1 | -1 | -1 | -1 | -1 | -1 |
| 2 | 36 | 42 | 48 | | 26 | 32 | 0 | 0 | -1 | -1 | -1 | -1 | | -1 | -1 | -1 | -1 | -1 | -1 | -1 | -1 | -1 | -1 |
| 3 | 35 | 40 | 45 | | 63 | 0 | -1 | 0 | 0 | -1 | -1 | -1 | | -1 | -1 | -1 | -1 | -1 | -1 | -1 | -1 | -1 | -1 |
| 4 | 38 | 46 | 54 | | 61 | 69 | -1 | -1 | 0 | 0 | -1 | -1 | | -1 | -1 | -1 | -1 | -1 | -1 | -1 | -1 | -1 | -1 |
| 5 | 41 | 52 | 63 | | 59 | 70 | -1 | -1 | -1 | 0 | 0 | -1 | | -1 | -1 | -1 | -1 | -1 | -1 | -1 | -1 | -1 | -1 |
| 6 | 39 | 48 | 57 | | 24 | 31 | -1 | -1 | -1 | -1 | 0 | 0 | | -1 | -1 | -1 | -1 | -1 | -1 | -1 | -1 | -1 | -1 |
| 7 | 43 | 56 | 69 | | 94 | 107 | -1 | -1 | -1 | -1 | -1 | 0 | | -1 | -1 | -1 | -1 | -1 | -1 | -1 | -1 | -1 | -1 |
| 8 | 32 | 34 | 36 | | 65 | 67 | -1 | -1 | -1 | -1 | -1 | -1 | | -1 | -1 | -1 | -1 | -1 | -1 | -1 | -1 | -1 | -1 |
| 9 | 52 | 74 | 96 | | 88 | 1 | -1 | -1 | -1 | -1 | -1 | -1 | | -1 | -1 | -1 | -1 | -1 | -1 | -1 | -1 | -1 | -1 |
| 10 | 49 | 68 | 87 | | 90 | 0 | -1 | -1 | -1 | -1 | -1 | -1 | | -1 | -1 | -1 | -1 | -1 | -1 | -1 | -1 | -1 | -1 |
| 11 | 51 | 72 | 93 | | 16 | 37 | -1 | -1 | -1 | -1 | -1 | -1 | | -1 | -1 | -1 | -1 | -1 | -1 | -1 | -1 | -1 | -1 |
| 12 | 34 | 38 | 42 | | 100 | 104 | -1 | -1 | -1 | -1 | -1 | -1 | | -1 | -1 | -1 | -1 | -1 | -1 | -1 | -1 | -1 | -1 |
| 13 | 50 | 70 | 90 | | 53 | 73 | -1 | -1 | -1 | -1 | -1 | -1 | | -1 | -1 | -1 | -1 | -1 | -1 | -1 | -1 | -1 | -1 |
| 14 | 31 | 32 | 33 | | 102 | 103 | -1 | -1 | -1 | -1 | -1 | -1 | | 0 | -1 | -1 | -1 | -1 | -1 | -1 | -1 | -1 | -1 |
| 15 | 54 | 78 | 102 | | 14 | 38 | -1 | -1 | -1 | -1 | -1 | -1 | | 0 | 0 | -1 | -1 | -1 | -1 | -1 | -1 | -1 | -1 |
| 16 | 46 | 62 | 78 | | 92 | 31 | -1 | -1 | -1 | -1 | -1 | -1 | | -1 | 0 | 0 | -1 | -1 | -1 | -1 | -1 | -1 | -1 |
| 17 | 53 | 76 | 99 | | 51 | 74 | -1 | -1 | -1 | -1 | -1 | -1 | | -1 | -1 | 0 | 0 | -1 | -1 | -1 | -1 | -1 | -1 |
| 18 | 44 | 58 | 72 | | 57 | 71 | -1 | -1 | -1 | -1 | -1 | -1 | | -1 | -1 | -1 | 0 | 0 | -1 | -1 | -1 | -1 | -1 |
| 19 | 37 | 44 | 51 | | 98 | 105 | -1 | -1 | -1 | -1 | -1 | -1 | | -1 | -1 | -1 | -1 | 0 | 0 | -1 | -1 | -1 | -1 |
| 20 | 42 | 54 | 66 | | 22 | 34 | -1 | -1 | -1 | -1 | -1 | -1 | | -1 | -1 | -1 | -1 | -1 | 0 | 0 | -1 | -1 | -1 |
| 21 | 40 | 50 | 60 | | 96 | 106 | -1 | -1 | -1 | -1 | -1 | -1 | | -1 | -1 | -1 | -1 | -1 | -1 | 0 | 0 | -1 | -1 |
| 22 | 47 | 64 | 81 | | 55 | 72 | -1 | -1 | -1 | -1 | -1 | -1 | | -1 | -1 | -1 | -1 | -1 | -1 | -1 | 0 | 0 | -1 |
| 23 | 48 | 66 | 84 | | 18 | 31 | -1 | -1 | -1 | -1 | -1 | -1 | | -1 | -1 | -1 | -1 | -1 | -1 | -1 | -1 | 0 | 0 |
| 24 | 45 | 60 | 75 | | 20 | 31 | -1 | -1 | -1 | -1 | -1 | -1 | | -1 | -1 | -1 | -1 | -1 | -1 | -1 | -1 | -1 | 0 |

FIG. 4 – TABLE. 2

**Description**

**FIELD OF THE INVENTION**

The present invention relates to fixed and mobile Broadband Wireless Access Networks implementing LDPC (Low Density Parity Check) block coding at the channel encoder, as recited in the preamble of claim 1. The invention is directed to a method for pseudo-puncturing exponent matrixes of LDPC codes to comply with different code-rates. The invention could be used in networks compliant with standard IEEE 802.16e [Ref.1].

According to [Ref.2], a linear block code consists of a set of fixed-length vectors called "codewords". The length of a codeword is the number of elements in the vector and is denoted by $n$. The elements of a codeword are selected from an alphabet of $q$ elements. When the alphabet consists of two symbols , 0 and 1, the code is a binary code and the elements of any codeword are called bits. There are $2^n$ possible codewords in a binary block code of length $n$. From these $2^n$ codewords, we may select $M = 2^k$ codewords ($k < n$) to form a code. Thus a block of $k$ information bits is mapped into a codeword of length $n$ selected from the set of $M = 2^k$ codewords. As known in the art, a LDPC code is simply a block code defined by a parity-check matrix that has a low density of ones (i.e. mostly zeros). Decoding is done iteratively using Belief Propagation (BP), to say, passing of extrinsic information between codeword elements and parity check equations. LDPC codes have the following advantages: **1)** designs have approached channel capacity within 0.0045 dB; **2)** structured designs offer the great performance with faster convergence and attractive silicon solutions; **3)** structured LDPC is a viable and attractive solution with significant gains over the legacy FEC system.

It is noted that the term "exponent matrix" is an expression widely used in the LDPC block coding/decoding art to conventionally denote a matrix whose elements, also called "exponents", represent permutation matrix of the $Z_f \times Z_f$ identity matrix; the null matrix, which is conventionally expressed by the element "-1", has also $Z_f \times Z_f$ dimensions. A permutation matrix is obtained by operating a right (or left) circular shift of the identity matrix (the elements of each row) of as many positions as its exponent. Consequently, sometimes in the art the term "exponent" used for the elements of the exponent matrix may be replaced with the equivalent term "shift-size".

**BACKGROUND ART**

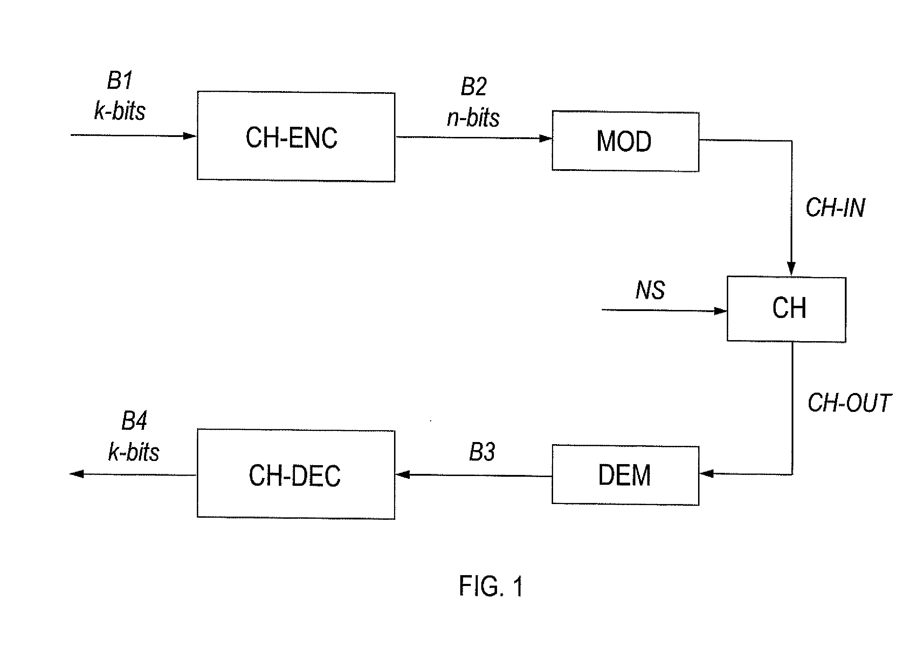

Let us consider a schematic example of a digital communication system model as the one shown in the block diagram of **Figure 1.**

The input of channel encoder CH_ENC is an information sequence $B1$ of $k$ bits to which a redundancy sequence of $r$ bits is added thereby producing an encoded sequence $B2$ of $n$ bits.

The code-rate $R$ is defined as the ratio between the information bits number $k$ and the encoded bits number $n$, thus $R = k / n$.

Modulator MOD transforms the encoded vector $B2$ into a modulated signal vector *CH_IN* which is in turn transmitted through a channel CH. Since the channel CH is usually subject to noisy disturbance *NS*, the channel output signal *CH_OUT* may differ from the channel input signal *CH_IN.*

At the receiving end, the channel output signal *CH_OUT* is processed by the demodulator DEM which performs the inverse operation of the modulator MOD and produces some likelihood ratio.

The channel decoder CH_DEC uses the redundancy in the received sequence $B3$ to correct the error in the information sequence of the received sequence $B3$ and produces a decoded signal $B4$ which is an information signal estimate.

State of the art encoder/decoder structures CH_ENC, CH_DEC use LDPC codes as proposed by the IEEE 802.16e Standard for Air Interface For Fixed and Mobile Broadband Wireless Access Systems [Ref.1].

LDPC codes are linear block codes. Linear block codes use a generator matrix **G** for the encoding operation and a parity-check matrix **H** for the decoding operation; nevertheless in its turn matrix **G** is most suitably obtained starting from designing the parity-check matrix $\mathbf{H}_{r \times n}$ ; obviously also the vice versa is possible. In conclusion, the parity-check matrix **H** can be used both for LDPC encoding and decoding.

For a block code with information sequence of $k$ bits, a codeword of $n$ bits and redundancy (parity) sequence of $r = n - k$ bits, the generator matrix **G** has $k \times n$ dimensions, and the parity-check matrix **H** has $r \times n = (n-k) \times n$ dimensions.

These two matrixes enjoy the orthogonal property, which states that for any ($k \times n$) matrix with $k$ linearly independent rows, there exists a matrix $\mathbf{H}_{r \times n}$ with $r = n-k$ linearly independent rows such that any row of $\mathbf{G}_{k \times n}$ is orthogonal to the rows of $\mathbf{H}_{r \times n}$ such that the following equation is satisfied:

$$\mathbf{G}_{k\times n} \cdot \mathbf{H}^{T}_{r\times n} = 0$$

$$(1)$$

The encoding operation is performed by means of the multiplication between the information sequence $\mathbf{U}_{1\times k}$ and the code generator matrix $\mathbf{G}_{k\times n}$. The result, of such multiplication, is the encoded output sequence $\mathbf{B2}_{1\times n}$ as follows:

$$\mathbf{B2}_{1\times n} = \mathbf{U}_{1\times k} \cdot \mathbf{G}_{k\times n}$$

$$(2)$$

At the receiving side, due to the orthogonal property between matrixes $\mathbf{G}_{k\times n}$ and $\mathbf{H}_{r\times n}$, the following equation should be satisfied:

$$\mathbf{H}_{r\times n} \cdot \mathbf{B}^{T}_{n\times 1} = 0$$

$$(3)$$

where $\mathbf{B}^{T}_{n\times 1}$ is the decoded received sequence which comprises the information signal estimate B4. If equation (3) is verified the information signal estimate B4 is correct otherwise the errors in the received sequence B3 exceed the correction capacity of the carried-out code.

The parity-check binary matrix $\mathbf{H}_{r\times n}$ is built combining in a certain manner three matrixes: the parity-check exponent matrix $\mathbf{H}_{exp}$ for a specific rate $R$; the "seed matrix" for that rate $R$, and the "spreading matrix" for a given spreading factor $Z_f$.

The exponent matrix is a non-binary matrix representing a block structured matrix.

The seed matrix is a binary matrix dedicated to each code-rate for masking the exponent matrix according to a compromise between performances and hardware complexity.

The spreading matrix is a square binary matrix of weight one and dimension $Z_f \times Z_f$, being $Z_f$ the desired spreading factor which in the known art is tied to the codeword length of the LDPC code.

In operation, the non-binary parity-check exponent matrix $\mathbf{H}_{exp}$ is element-by-element multiplied by the seed matrix; the result is an opportunely masked $\mathbf{H}_{exp}$ matrix, which in turn is expanded to the parity-check binary matrix $\mathbf{H}_{r\times n}$ (called the expanded matrix $\mathbf{H}_{r\times n}$).

There are several design techniques for generating the parity-check matrix $\mathbf{H}_{r\times n}$ of a LDPC code. The most used generating technique in LDPC code design is the semi-random technique.

When realized with semi-random technique, the expanded matrix $\mathbf{H}_{r\times n}$ is constituted of two sub-matrixes: the first sub-matrix is a random matrix having $(n-k)\times k=r\times k$ size and the second one is a sub-matrix of $(n-k)\times(n-k)=r\times k$ size, conventionally called semi-deterministic sub-matrix.

It is noted that the exponent matrix is typically built with the maximum spreading factor $Z_0$ which corresponds to the maximum codeword size. However, it is possible to implement codewords of variable sizes.

When a different codeword size is desired, whose size is smaller than the maximum size, a spreading factor $Z_f$ smaller than $Z_0$ is required. In such cases, it is possible to convert the exponent matrix built with maximum spreading factor $Z_0$ into an exponent matrix having spreading factor $Z_f < Z_0$ by using some translation formulas as, for example, relation (129a) reported in IEEE 802.16e Standard [Ref.1] at page 627.

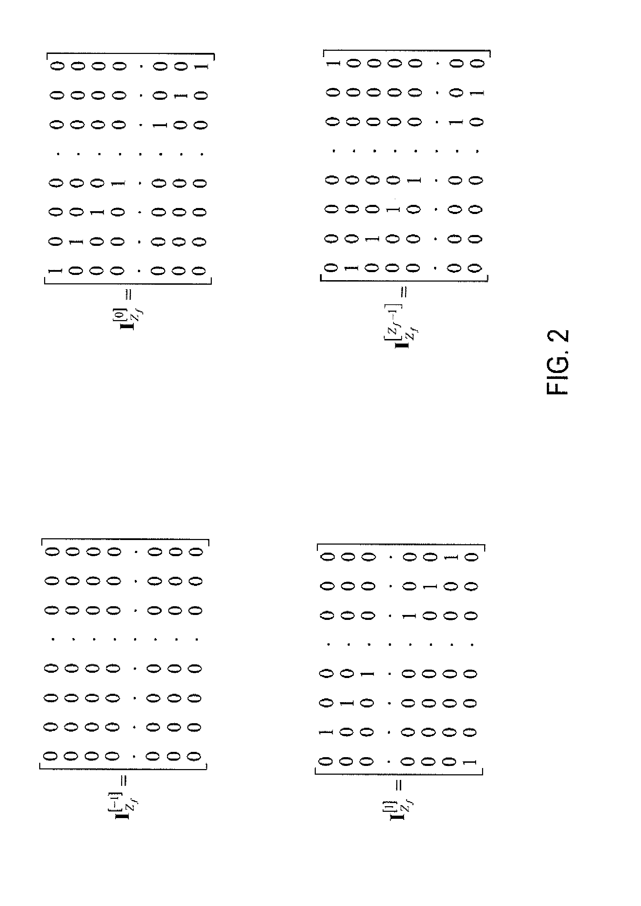

The elements of the parity-check exponent matrix $\mathbf{H}_{exp}$ comprised between 0 and $Z_f$-1 represent permutation matrixes of the identity matrix (the one with weight equal to "1" for each row and for each column) with dimensions $Z_f \times Z_f$. The exponent indicates the size of circular shift to the right of the row elements of the identity matrix, as shown in the matrixes $\mathbf{I}^{[0]}_{Z_f}, \mathbf{I}^{[1]}_{Z_f}, \ldots, \mathbf{I}^{[Z_f-1]}_{Z_f}$ reported in **figure 2.** The exponent matrix element "-1" conventionally represents a null square matrix of size $Z_f \times Z_f$, as shown in the matrix $\mathbf{I}^{[-1]}_{Z_f}$ further reported in **figure 2.** All non-negative exponents have meaning, for example the "0" exponent corresponds to the identity matrix element. The skilled in the art easily understands that same benefits may be obtained if the cyclic shift is a cyclic shift to the left instead than a one to the right.

The parity-check exponent matrix $\mathbf{H}_{exp}$ is used in the implementation of both LDPC encoder and LDPC decoder. The IEEE 802.16e [Ref.1] shows an efficient method for LDPC encoding (Annex H3, Method 2, page 821) which allows to reduce the LDPC encoder hardware complexity, on condition that the parity-check exponent matrix $\mathbf{H}_{exp}$ is opportunely built with semi-random techniques. Accordingly, three new indexes $n_b$, $r_b$, $k_b$ are derived from $n$, $r$, $k$, e.g. dividing them by $Z_f$. The two indexes $n_b$, $r_b$ respectively indicate the number of columns and the number of rows of the exponent matrix $\mathbf{H}_{exp}$, and index $k_b$ indicates the number of columns dedicated to the only structured information sequence.

As previously said, the number of columns $n_b$ of the exponent matrix $\mathbf{H}_{exp}$ is computed from the largest codeword $n_0$ and the highest spreading factor $Z_0$ as follows: $n_b = n_0/Z_0$. The number of rows $r_b$ of the exponent matrix $\mathbf{H}_{exp}$ depends on the code-rate $R_j$ as follows: $r_b = n_b - k_b = n_b (1 - R_j)$.

Accordingly, the $\mathbf{H}_{exp}$ matrix is split into a random sub-matrix ($r_b \times k_b$), and a semi-deterministic sub-matrix ($r_b \times k_b$). In its turn the semi-deterministic sub-matrix is split into a conventionally called semi-deterministic column vector $\mathbf{C}v$ ($r_b \times 1$), constructed in an opportune way, and a deterministic part which includes a bidiagonal matrix as known from the art. In order to simplify the decoder (see Ref.1 - at the bottom of page 626), the column vector $\mathbf{C}v$ is designed to have only three elements different from "-1", representing the null matrix, that the first and the last element are equal, and that only one randomly chosen element is equal to "0", representing the identity matrix.

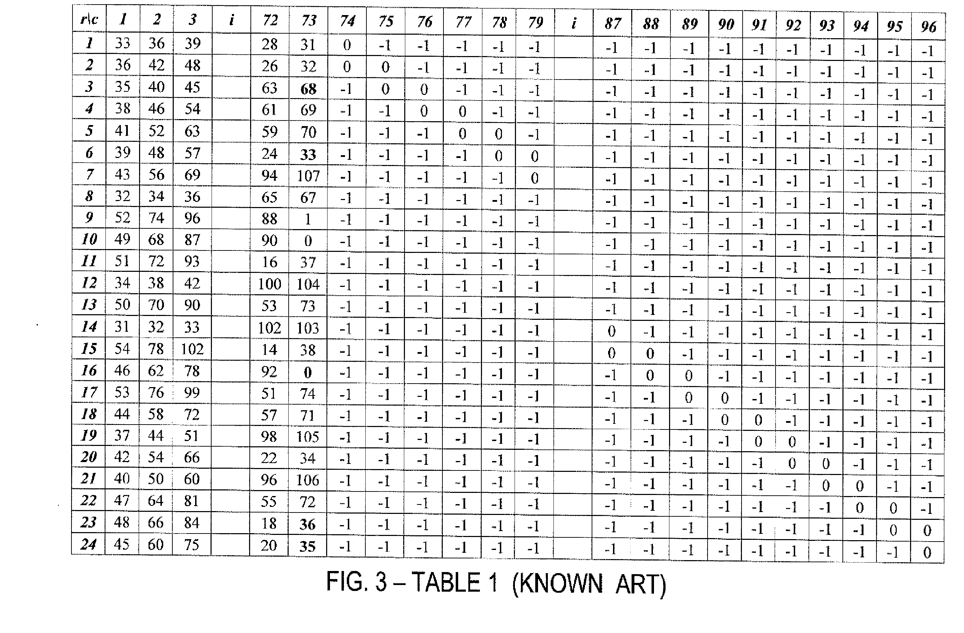

With reference to **Table 1** of **fig.3,** let us consider a base model LDPC code rate $R_0 = 3/4$ ; the block structured codeword is $n_b = 96$ , the block structured information sequence is $k_b = 72$, the block structured parity sequence is $r_b = 24$ and spreading factor $Z_0 = 108$. The column index of vector $\mathbf{C}v$ is: $k_b + 1 = 73$. The LDPC codeword length ($n$) is computed using the exponent matrix column number ($n_b$) and the spreading factor ($Z_0$), so that $n = n_b \cdot Z_0 = 10368$.

The information length ($k$) is computed using the block structured information sequence ($k_b$) and the spreading factor ($Z_0$) , so that $k = k_b \cdot Z_0 = 7776$.

The parity length ($r$) is computed using the block structured parity sequence ($r_b$) and the spreading factor ($Z_0$) , so that $r = r_b \cdot Z_0 = 2592$.

## TECHNICAL PROBLEM

As known in the art, the base model as the one depicted in **Table 1,** can be punctured to increase the code rate. Classical puncturing operation for LDPC codes is carried out on single bit of the expanded parity-check binary matrix $\mathbf{H}_{r \times n}$ and consists of deleting a prefixed number of bits which are not transmitted so as to increase the throughput and replacing them by erasures at the decoder. To maintain acceptable performances, for LDPC codes, the puncturing operation shall not reduce the mean column weight under a prefixed value. In order to minimize the performance degradation at the decoder, it is desirable to puncture bit-nodes of the smallest degree in the bipartite Tanner graph, which is essentially a visual representation of the parity check matrix $\mathbf{H}_{r \times n}$. Bit-nodes of the smallest degree are the ones with a minor number of connections to the check nodes (parity nodes).

Standardized random sub-matrix, tied to the information sequence, has mean column weight bigger or equal to 3, while the deterministic sub-matrix, tied to the parity sequence, has column weight equal to 2. If the number of bit-nodes of the smallest degree is bigger than the bit number to be punctured, it is necessary a pre-processing to find the optimum puncturing pattern. According to the teaching at [Ref.2], the optimum pattern for a parity-check matrix built with semi-random technique is an alternate pattern on the parity sub-matrix. Since the deterministic sub-matrix has weight equal to 2 for row and for column, the alternate puncturing pattern longer than half parity sequence produces deterministic sub-matrix rows with weight equal to zero which leads to a remarkable LDPC code performance degradation.

## SUMMARY OF THE INVENTION

It is therefore an object of the present invention to overcome the above mentioned limitations in puncturing operation of a LDPC block code to the aim of achieving higher rates R of the channel code.

The invention achieves said object by providing a method of puncturing LDPC block code of information sequences of $k$ bits structured into semi-random parity-check exponent matrixes, each element of which, namely the exponent, being expanded into a permutation matrix by a cyclic shift of the identity matrix with a shift-size corresponding to the value of said exponent, and every parity-check exponent matrix being composed of two contiguous sub-matrixes with the same number $r_b$ of rows and a total of $n_b$ columns, a first one of the twos being a random sub-matrix of $k_b$ columns that accounts for a block of information bits and a second one being a composite sub-matrix of $r_b$ columns that accounts for parity-check bits, the composite sub-matrix including a deterministic part of $r_b$ -1 columns and a first column vector whose elements have a value which represents the null matrix, with the only exception of the first and the last element that include a same randomly selected exponent, and of a third element in a random position between the twos having a value which represents the identity matrix, the method including the following steps:

a) providing a mother exponent table of $r_b$ rows and $n_b - \dfrac{n_0}{Z_0}$ columns determined at the longest codeword $n_0$ and the highest spreading factor $Z_0$, thus giving rise to the lowest code-rate $R_0$;

b) for each generic code-rate $R_x$, being $x$ a variable positive integer such that $r_x = r_b - x$ is greater than or equal to the average column weight of the code, forcing the elements of mother exponent table with coordinates $r_x, k_b + 1$ to the same value of the element with coordinates $1, k_b + 1$, and forcing to the exponent of the identity matrix one only remaining element addressed by coordinates between $1, k_b + 1$ and $r_{x\_M}, k_b + 1$, *being $r_{x\_M}$* the row number coming from the highest code-rate;

c) providing an exponent matrix $\mathbf{H}_{\text{exp-}x}$ for any code-rate $R_x$ from a corresponding sub-table of the mother exponent table forced at the previous step, by including in the sub-table *the $r_x = r_b - x$* rows and the $n_x = n_b - x$ columns of the lowest indexes, and replacing with the conventional exponent of the null matrix each unforced element relevant to that $x$, excepting the element with coordinates *1, $k_b + 1$*, as disclosed in claim 1.

The puncturing method of above corresponds to a first realizzative form of the invention (the only one detailed in the figures) in which, independently of the number of code-rates supported by the mother table, one only element of the column addressed by index $k_b + 1$ is forced to the exponent of the identity matrix.

An alternative step b) recites as in the following:

b) for each generic code-rate $R_x$, being $x$ a variable positive integer such that $r_x = r_b - x$ is greater than or equal to the average column weight of the code, forcing the elements of mother exponent table with *coordinates $r_x, k_b + 1$* to the same value of the element with coordinates $1, k_b + 1$, and forcing one only remaining element different from those addressed by *coordinates $r_x, k_b + 1$* to the exponent of the identity matrix, as disclosed in the independent claim 2.

The puncturing method of alternative step b) corresponds to a second realizzative form of the invention (not detailed in the figures) in which, for each implemented code-rate a respective element of the column of mother table addressed by index $k_b + 1$ is forced to the exponent of the identity matrix.

It must be point out that, differently from the known art in which puncturing is performed on as many binary matrixes as the implemented code-rates, the puncturing of LDPC codes according to the proposed invention is performed starting from a mother exponent table, which is unique for all implemented code-rates, and puncturing involves a plurality of blocks simultaneously. Thus the puncturing strategy is quite independent of the code-rate, and this is a very distinguish feature.

Because of the different strategy in respect of classical puncturing operation, when puncturing is referred to the mother exponent table, and thus the derived exponent matrixes, it will be called pseudo-puncturing.

Additional features of the present invention which are believed to be novel are set forth with particularity in the appended claims.

Other object of the invention is a system having means operating according to the steps of the methods disclosed in the appended claims.

According to an aspect of the invention, said forcing at step b) is carried out on the same mother exponent table for many code-rate $R_x$.

According to another aspect of the invention, said forcing at step b) is carried out by masking the exponent matrix $\mathbf{H}_{\text{exp-}x}$ for the code-rate $R_x$ with a seed matrix dedicated to that code-rate.

According to the invention, the step c) of providing an exponent matrix $\mathbf{H}_{\text{exp-}x}$ can be performed with the aim of preserving in memory the mother exponent table, thus copying the specific sub-table relevant to the actual exponent matrix $\mathbf{H}_{\text{exp-}x}$ for code-rate $R_x$ each time it is requested. Bounded to the above preservative aim, from now onwards in the description, step c) is alternatively said to be performed by deleting the last $x$ columns and the last $x$ rows from the mother exponent table.

According to the invention, let us consider a mother LDPC code with rate $R_0 = 3/4$ the mother exponent table (Table 1) has $n_b = 96$ columns and $r_b = 24$ rows ($k_b = n_b - r_b = 72$), being $n_b$ the block structured codeword, $k_b$ the block structured information sequence and $r_b$ the block structured parity sequence. After having built the mother exponent table (base model exponent matrix), with the known art, it is necessary to act on the first column vector of the deterministic sub-matrix (semi-random technique) as instep b) for each punctured LDPC code rate to carry-out.

In the proposed invention the punctured LDPC code with rate $R_x$ can be obtained eliminating, from the mother exponent table, the $x$ columns of highest index, concerning the parity sub-matrix columns, and the $x$ rows of highest index. So doing the code rate becomes:

$$R_x = \frac{(n_b - x) - (r_b - x)}{n_b - x} = \frac{n_b - r_b}{n_b - x} = \frac{k_b}{n_b - x} = \frac{k_b}{n_{bx}} \quad , \tag{4}$$

where $k_b$, block structured information sequence, remains unchanged while the codeword is reduced to $(n_b - x) \cdot Z_f = n_{bx} \cdot Z_f$ and also the row number of the binary parity-check matrix is reduced to $(r_b - x) \cdot Z_f = r_{bx} \cdot Z_f$.

Let us wish to carry-out the punctured LDPC codes with code rate $R_1, R_2, R_3, ....., R_{18}$.

The highest code rate $R_{18}$ is fixed from the mean column weight which is, in this case for example, equal to 4; then because the parity sub-matrix has weight equal to 2, the block structured exponent matrix with rate $R_{18}$ will have at least six rows. To extract the pseudo-punctured exponent matrix from the base model LDPC code it is necessary to operate in this way:

$$R_0 = \frac{k_b}{n_b} = \frac{72}{96} = \frac{3}{4} \; ; \qquad\qquad R_1 = \frac{k_b}{n_b - 1} = \frac{k_b}{n_{b1}} = \frac{72}{95} \; .$$

The punctured LDPC code with rate $R_1$ is obtained eliminating the column 96 and the row 24 of the base model exponent table.

The punctured LDPC code with rate $R_2 = \frac{k_b}{n_b - 2} = \frac{k_b}{n_2} = \frac{72}{94} = \frac{36}{47}$ is obtained eliminating the columns 96, 95 and the rows 24, 23 of the base model exponent table. The punctured LDPC code with rate $R_3 = \frac{k_b}{n_b - 3} = \frac{k_b}{n_3} = \frac{72}{93} = \frac{24}{31}$ is obtained eliminating the columns 96, 95, 94 and the rows 24, 23, 22 of the base model exponent table.

Finally, the punctured LDPC code with rate $R_{18} = \frac{k_b}{n_b - 18} = \frac{k_b}{n_{18}} = \frac{72}{78} = \frac{12}{13}$ is obtained eliminating the columns 96, 95, 94,......,79 and the rows 24, 23, 22,......,7 of the base model exponent table.

The puncturing operation of the LDPC code, according to the proposed invention, is carried-out for spreading factor ($Z_f$) multiples; by comparison the classical puncturing operation of the LDPC code is instead carried out for single bit.

When a LDPC code is punctured for a bit number which isn't spreading factor multiple it can be implemented in this way:

$puncture\_bits = (a \cdot Z_f + b)\_bits$ with $1 \le b < Z_f$,

where $(a \cdot Z_f)\_bits$ are punctured as in the proposed invention way and $b\_bits$ are punctured successively with the classical operation.

In this way the punctured LDPC code so carried-out (proposed invention puncturing + classical puncturing) has better performances than LDPC code punctured with the only classical puncturing operation.

Each punctured LDPC code exponent matrix, so obtained from the relevant table, must be masked with a dedicated seed matrix. As previously said, the mean column weight of value $w_c = 4$ determines the highest rate (minimum row number) to have a LDPC code with good performances. Then for a mean column weight $w_c = 4$ the element number, for unitary spreading factor, of the parity-check matrix equal to "1" are:

$$R_0 = 3/4 \quad \Rightarrow \quad overall\_H\_weight = n_b \cdot w_c = 96 \cdot 4 = 384 \quad \Rightarrow$$
$$\Rightarrow \quad mother\_LDPC\_code \; ;$$

$$R_h = 12/13 \quad \Rightarrow \quad overall\_H\_weight = n_{b2} \cdot w_c = 78 \cdot 4 = 312 \quad \Rightarrow$$

$$\Rightarrow \quad punctured\_LDPC\,code \ .$$

## ADVANTAGES OF THE INVENTION

The digital processing (hardware complexity or arithmetic operation number) using the puncturing technique according to the proposed invention, decreases with increasing the number of punctured parity elements. In fact the overall parity-check matrix weight provides the hardware complexity of the LDPC code implementation. Compared to mother LDPC code which is used in the classical puncturing operation, eliminating a certain number of columns and rows, the overall punctured matrix weight is lower than the overall mother matrix weight for equal mean column weight. Furthermore, an unique model table shall be stored for deriving several exponent matrixes $\mathbf{H}_{exp-x}$ for various code rates $R_x$.

For example, to carry-out a punctured LDPC code with rate $R_h$ =12/13 , according to the proposed invention, we have a reduction of the arithmetic operation number of the 18.75% [(1-312/384)*100] compared to the mother LDPC code; the punctured LDPC code is carried-out for a bit punctured number equal to multiple spreading factors.

The mother exponent matrix, built according to the proposed invention, can be also used with the classical puncturing operation.

A punctured LDPC code, so obtained, allows to improve the performances, compared to a LDPC code realized with classical puncturing technique, because the mean column weight remains unchanged and equal to the mean column weight of the mother exponent matrix.

The processing of the proposed invention doesn't change the block structured exponent matrix characteristics because each element maintains the characteristic of unitary weight permutation matrix.

Moreover, said processing steps do not change the characteristics of the expanded parity-check matrix of being a binary matrix with a low density of "1".

## BRIEF DESCRIPTION OF THE DRAWINGS

The features of the present invention which are considered to be novel are set forth with particularity in the appended claims. The invention and its advantages may be understood with reference to the following detailed description of an embodiment thereof taken in conjunction with the accompanying drawings given for purely non-limiting explanatory purposes and wherein:

- **figure 1** shows a block diagram schematically illustrating a suitable digital communication system for implementing the present invention;

- **figure 2** shows different permutation matrixes, wherein, $\mathbf{I}_{Z_f}^{[-1]}$ corresponds to the null matrix and $\mathbf{I}_{Z_f}^{[0]}, \mathbf{I}_{Z_f}^{[1]}, \mathbf{I}_{Z_f}^{[Z_f-1]}$ correspond to a cyclic shift to the right of the identity matrix for a shift-size indicated by the exponent;

- **figure 3** shows a LDPC base model exponent **Table 1** built as in the known art for code rate $R_0 = \dfrac{3}{4}$ , to be used as a starting point to implement the puncturing method of the present invention;
- **figure 4** shows a **Table 2** obtained from Table 1 modified according to the proposed invention;
- **figure 5** shows a **Table 3** obtained by masking Table 2 with a dedicated seed matrix;

- **figure 6** shows a **Table 4** obtained by puncturing Table 2 according to the method of the invention for code rate $R_1 = \dfrac{72}{95}$ and masking it with a dedicated seed matrix;

- **figure 7** shows a **Table 5** obtained by puncturing Table 2 according to the method of the invention for code rate $R_8 = \dfrac{9}{11}$ and masking it with a dedicated seed matrix;

- **figure 8** shows a **Table 6** obtained by puncturing Table 2 according to the method of the invention for code rate $R_{18} = \dfrac{12}{13}$ and masking it with a dedicated seed matrix.

## DETAILED DESCRIPTION OF SOME EMBODIMENTS OF THE INVENTION

Let us consider a base model LDPC code rate $R_0 = 3/4$; the block structured codeword is $n_b = 96$, the block structured information sequence is $k_b = 72$, the block structured parity sequence is $r_b = 24$ and spreading factor $Z_0 = 108$.

The LDPC codeword length $n = n_b \cdot Z_0 = 10368$ is computed using the exponent matrix column number ($n_b$) and the spreading factor ($Z_0$).

The information length $k = k_b \cdot Z_0 = 7776$ is computed using the block structured information sequence ($k_b$) and the spreading factor ($Z_0$).

The parity length $r = r_b \cdot Z_0 = 2592$ is computed using the block structured parity sequence ($r_b$) and the spreading factor ($Z_0$).

With reference to **fig.3**, let us build, with known art, the base model exponent matrix of **Table 1** which, opportunely modified, allows to implement the base model LDPC code and the punctured LDPC codes with the following rates $R_1$, $R_8$, $R_{18}$. More precisely:

$$R_0 = \frac{k_b}{n_b} = \frac{72}{96} = \frac{3}{4} = 0.75 \quad \Rightarrow \quad H(r_b, n_b) = H(24, 96) \quad \Rightarrow \quad k_b + 1 = 73$$

$$R_1 = \frac{k_b}{n_b - 1} = \frac{k_b}{n_{b1}} = \frac{72}{95} = 0.7579 \quad \Rightarrow \quad H(r_{b1}, n_{b1}) = H(23, 95) \quad \Rightarrow \quad k_b + 1 = 73$$

$$R_8 = \frac{k_b}{n_b - 8} = \frac{k_b}{n_{b8}} = \frac{72}{88} = \frac{9}{11} = 0.8182 \quad \Rightarrow \quad H(r_{b8}, n_{b8}) = H(16, 88) \quad \Rightarrow \quad k_b + 1 = 73$$

$$R_{18} = \frac{k_b}{n_b - 18} = \frac{k_b}{n_{b18}} = \frac{72}{78} = \frac{12}{13} = 0.9231 \quad \Rightarrow \quad H(r_{b18}, n_{b18}) = H(6, 78) \quad \Rightarrow \quad k_b + 1 = 73$$

To make the base model exponent matrix suitable for implementing the LDPC code rate $R_0 = 3/4$ and for implementing the punctured LDPC code rates $R_1 = 72/95$, $R_8 = 9/11$, $R_{18} = 12/13$ we have to operate on the first column vector of the deterministic sub-matrix ($k_b + 1 = 73$). The ($k_b + 1$) column elements to modify, highlighted in bold in **Table 1,** have the following coordinates:

$(3, k_b+1) = 68$; $(6, k_b+1) = 33$; $(16, k_b+1) = 0$; $(23, k_b+1) = 36$; and $(24, k_b + 1) = 35$.

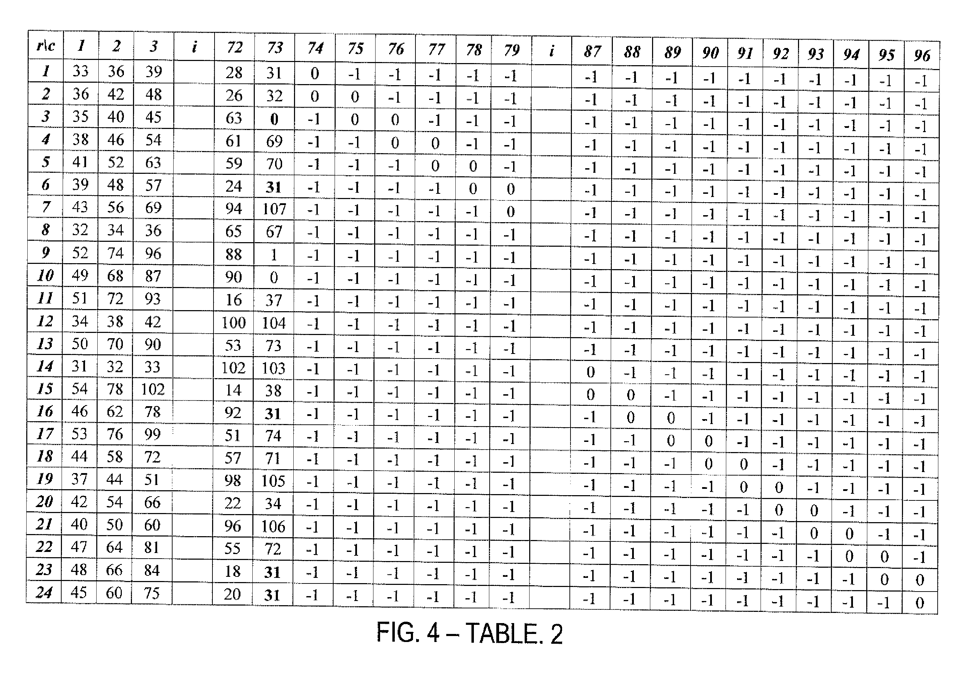

With reference to **fig.4,** the ($k_b + 1$) column elements highlighted in bold in Table 1, are modified as shown highlighted in bold in **Table 2.** The modified elements have the following coordinates:

$(3, k_b + 1) = 0 \Rightarrow$ this element is common to all four the codes $R_0, R_1, R_8, R_{18}$;

$(6, k_b + 1) = (1, k_b + 1) = 31 \Rightarrow$ the $6^{th}$ row element is dedicated to punctured LDPC code $R_{18} = 12/13$;

$(16, k_b + 1) = (1, k_b + 1) = 31 \Rightarrow$ the $16^{th}$ row element is dedicated to punctured LDPC code $R_8 = 9/11$ ;

$(23, k_b + 1) = (1, k_b + 1) = 31 \Rightarrow$ he $23^{th}$ row element is dedicated to punctured LDPC code $R_1 = 72/95$ ;

$(24, k_b + 1) = (1, k_b + 1) = 31 \Rightarrow$ he $24^a$ row element is dedicated to base model LDPC code $R_0 = 3/4$.

In this way the semi-deterministic column vector will keep its characteristics of semi-random technique construction. In fact when the dedicated seed matrix will be placed on top to each exponent matrix the $(k_b + 1)$ column will have only three elements different from zero (null matrix = "-1" conventional): the first and the last element will be equal $[(r_{bx}, k_b + 1) = (1, k_b + 1) = 31]$, and the third element, but can be anyone, will be equal to the identity matrix $[(3, k_b + 1) = 0]$.

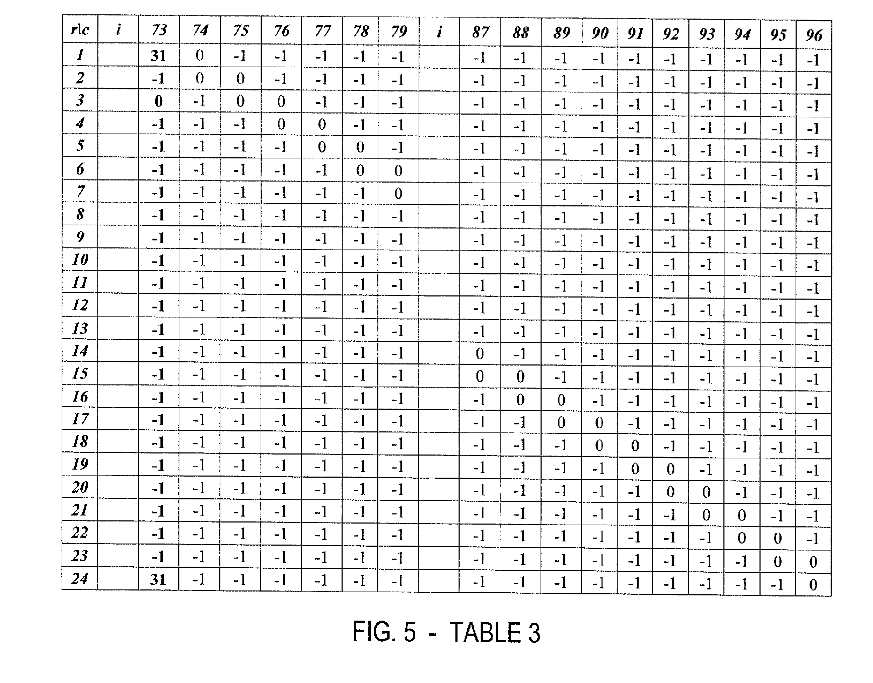

With reference to **fig.5,** to obtain the punctured LDPC code relevant to **Table 3** with rate $R_0 = k_b / n_b = 3/4$ , it is sufficient to place upon the exponent matrix relevant to Table 2 the dedicated seed matrix with an opportune mean column weight to reach the wished performances. In **Table 3** the first column vector of the deterministic sub-matrix $(k_b + 1 = 73)$ is shown in bold; this column must be built with three elements different from zero for minimizing the complexity hardware of the LDPC encoder ([Ref.1] - Annex H - Method 2 ). Because the seed matrix is not subject of the proposed invention, the columns from 1 to $k_b = 72$ of Table 3 are omitted.

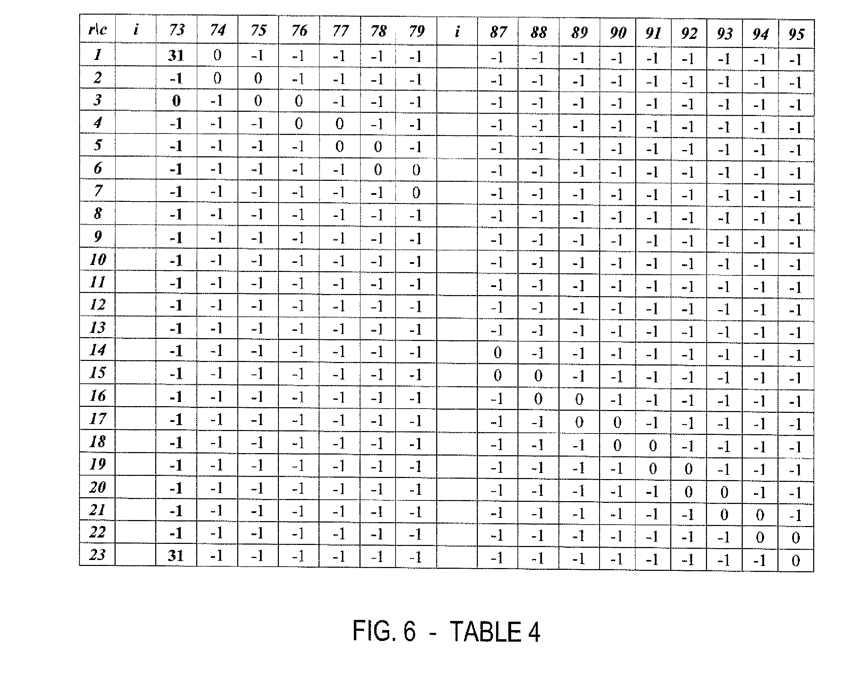

With reference to **fig.6,** to obtain the punctured LDPC code relevant to **Table 4** with rate $R_1 = k_b / n_{b1} = 72/95$ it is sufficient to eliminate the column *96* and row *24* from the mother exponent Table 2. In this case the punctured LDPC codeword has length $n_1 = n_{b1} \cdot Z_0 = 95 \cdot 108 = 10260$. To obtain the wished performances it is necessary to place on top to the extracted exponent matrix $\mathbf{H}_{exp-1} = \mathbf{H}(r_{b1}, n_{b1}) = \mathbf{H}(23, 95)$ the dedicated seed matrix with an opportune mean column weight. In **Table 4** is shown the first column vector of the deterministic sub-matrix $(k_b + 1 = 73)$ in bold; this column must be built with three elements different from zero for minimizing the complexity hardware of the LDPC encoder. Because the seed matrix is not subject of this proposed invention the columns from 1 to $k_b = 72$ of Table 4 are omitted.

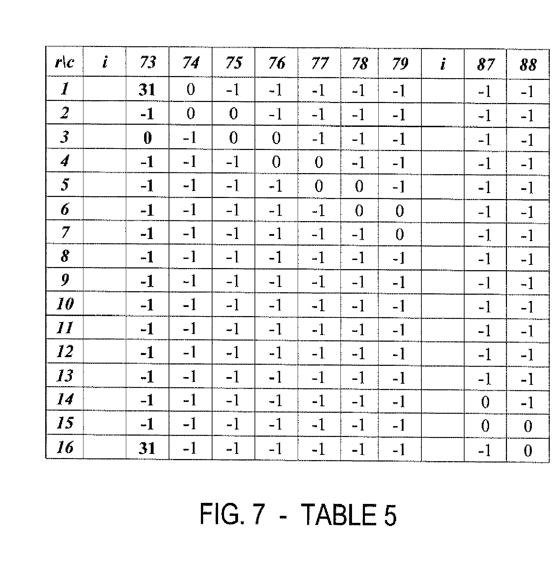

In the same way, with reference to **fig.7,** the punctured LDPC code of **Table 5** with rate $R_8 = k_b / n_{b8} = 9/11$ is obtained eliminating the columns 96, 95, ... , 89 and the rows 24, 23, ... , 17 from the mother exponent Table 2. This punctured LDPC code has a codeword length $n_8 = n_{b8} \cdot Z_0 = 88 \cdot 108 = 9504$. The wished performances are obtained placing on top, to the extracted exponent matrix $\mathbf{H}_{exp-8} = \mathbf{H}(r_{b8}, n_{b8}) = \mathbf{H}(16, 88)$ the dedicated seed matrix with an opportune mean column weight. In **Table 5** is shown the first column vector of the deterministic sub-matrix $(k_b + 1 = 73)$ in bold; this column must be built with three elements different from zero for minimizing the complexity hardware of the LDPC encoder. Because the seed matrix is not subject of the invention the columns from 1 to $k_b = 72$ of **Table 5** are omitted.

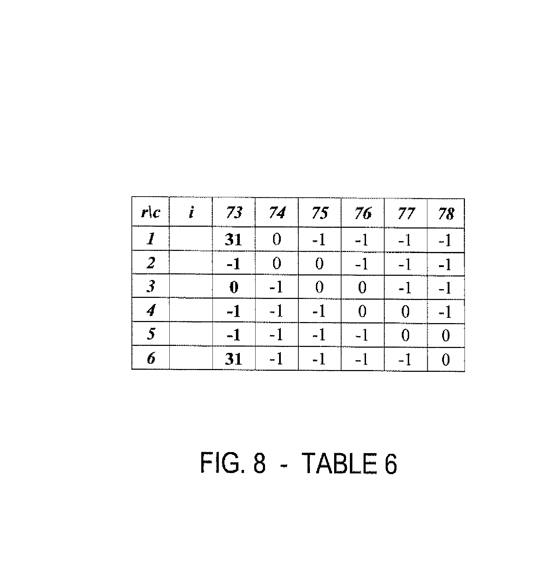

With reference to **fig.8,** the punctured LDPC code of **Table 6** with rate $R_{18} = k_b / n_{b18} = 12/13$ is obtained eliminating the columns 96, 95, ... , 79 and the rows 24, 23, ... , 7 from the mother exponent Table 2. This punctured LDPC code has a codeword length $n_{18}, = n_{b18} \cdot Z_0 = 78 \cdot 108 = 8424$. The wished performances are obtained placing on top, to the extracted exponent matrix $\mathbf{H}_{exp-18} = \mathbf{H}(r_{b18}, n_{b18}) = \mathbf{H}(6, 78)$, the dedicated seed matrix with an opportune mean column weight. In **Table 6** is shown the first column vector of the deterministic sub-matrix $(k_b + 1 = 73)$ in bold; this column must be built with three elements different from zero for minimizing the complexity hardware of the LDPC encoder. Because the seed matrix is not subject of the proposed invention the columns from 1 to $k_b = 72$ of Table 6 are omitted.

Although the invention has been described with particular reference to a preferred embodiment, it will be evident to those skilled in the art, that the present invention is not limited thereto, but further variations and modifications may be applied without departing from the scope of the invention as defined by the annexed claims.

## References

[Ref.1] IEEE Std 802.16e - Air Interface for Fixed and Mobile Broadband Wireless Access Systems - 28 February 2006.

[Ref.2] Jon G. Proakis, "DIGITAL COMMUNICATIONS", fourth edition; published by McGraw-Hill, year 2001, ISBN 0-07-232111-3.

[Ref.3] Zaheer, Zummo, Landolsi, Kousa: "Improved regular and semi-random rate-compatible low-density parity-check codes with short block lengths"; published on IET (Institution Engineering Technology) Communications 2008, vol. 2, No. 7, pp. 960-971.

## Used acronyms

BP       Belief Propagation
LDPC    Low Density Parity Check Code
WiMAX   Worldwide Interoperability for Microwave Access

## Claims

1. Method of puncturing LDPC block code of information sequences of $k$ bits structured into semi-random parity-check exponent matrixes, each element of which, namely the exponent, being expanded into a permutation matrix $( \mathbf{I}_{Z_f}^{[0]}, \mathbf{I}_{Z_f}^{[1]}, \mathbf{I}_{Z_f}^{[Z_f-1]} )$ by a cyclic shift of the identity matrix $( \mathbf{I}_{Z_f}^{[0]} )$ with a shift-size corresponding to the value of said exponent, and every parity-check exponent matrix being composed of two contiguous sub-matrixes with the same number $r_b$ of rows and a total of $n_b$ columns, a first one of the twos being a random sub-matrix of $k_b$ columns that accounts for a block of information bits and a second one being a composite sub-matrix of $r_b$ columns that accounts for parity-check bits, the composite sub-matrix including a deterministic part of $r_b$ -1 columns and a first column vector whose elements have a value which represents the null matrix $( \mathbf{I}_{Z_f}^{[-1]} )$, with the only exception of the first and the last element that include a same randomly selected exponent, and of a third element in a random position between the twos having a value which represents the identity matrix $( \mathbf{I}_{Z_f}^{[0]} )$, __characterized in that__ includes the following steps:

    a) providing a mother exponent table (Tab.1) of $r_b$ rows and $n_b = \dfrac{n_0}{Z_0}$ columns determined at the longest codeword $n_0$ and the highest spreading factor $Z_0$, thus giving rise to the lowest code-rate $R_0$;
    b) for each generic code-rate $R_x$, being $x$ a variable positive integer such that $r_x = r_b - x$ is greater than or equal to the average column weight of the code, forcing (Tab.2) the elements of mother exponent table (Tab.1) with coordinates $r_x$, $k_b$ + 1 to the same value of the element with coordinates 1, $k_b$ +1, and forcing to the exponent of the identity matrix $( \mathbf{I}_{Z_f}^{[0]} )$ one only remaining element addressed by coordinates between 1, $k_b$ +1 1 and $r_{x\_M}$, $k_b$ + 1, being $r_{x\_M}$ the row number coming from the highest code-rate;
    c) providing an exponent matrix $\mathbf{H}_{\text{exp-}x}$ for any code-rate $R_x$ from a corresponding sub-table (Tab.3, Tab.4, Tab. 5, Tab.6) of the mother exponent table forced at the previous step, by including in the sub-table the $r_x = r_b - x$ rows and the $n_x = n_b -x$ columns of the lowest indexes, and replacing with the conventional exponent of the null matrix $( \mathbf{I}_{Z_f}^{[-1]} )$ each unforced element relevant to that $x$, excepting the element with coordinates 1, $k_b$ +1.

2. Method of puncturing LDPC block code of information sequences of $k$ bits structured into semi-random parity-check exponent matrixes, each element of which, namely the exponent, being expanded into a permutation matrix $( \mathbf{I}_{Z_f}^{[0]}, \mathbf{I}_{Z_f}^{[1]}, \mathbf{I}_{Z_f}^{[Z_f-1]} )$ by a cyclic shift of the identity matrix $( \mathbf{I}_{Z_f}^{[0]} )$ with a shift-size corresponding to the value of said exponent, and every parity-check exponent matrix being composed of two contiguous sub-matrixes with the same number $r_b$ of rows and a total of $n_b$ columns, a first one of the twos being a random sub-matrix of $k_b$ columns that accounts for a block of information bits and a second one being a composite sub-matrix of $r_b$ columns that accounts for parity-check bits, the composite sub-matrix including a deterministic part of $r_b$ -1 columns and a first column vector whose elements have a value which represents the null matrix $( \mathbf{I}_{Z_f}^{[-1]} )$, with the only exception of the first and the last element that include a same randomly selected exponent, and of a third element in a random position between the twos having a value which represents the identity matrix $( \mathbf{I}_{Z_f}^{[0]} )$, __characterized in that__ includes the following steps:

a) providing a mother exponent table (Tab.1) of $r_b$ rows and $n_b = \dfrac{\breve{}}{Z_0}$ columns determined at the longest codeword $n_0$ and the highest spreading factor $Z_0$, thus giving rise to the lowest code-rate $R_0$;

b) for each generic code-rate $R_x$, being $x$ a variable positive integer such that $r_x = r_b - x$ is greater than or equal to the average column weight of the code, forcing (Tab.2) the elements of mother exponent table (Tab.1) with coordinates $r_x$, $k_b$ +1 to the same value of the element with coordinates 1, $k_b$ +1, and forcing one only remaining element different from those addressed by coordinates $r_x$, $k_b$ +1 to the exponent of the identity matrix ($\mathbf{I}_{Z_f}^{[0]}$);;

c) providing an exponent matrix $\mathbf{H}_{\text{exp-}x}$ for any code-rate $R_x$ from a corresponding sub-table (Tab.3, Tab.4, Tab. 5, Tab.6) of the mother exponent table forced at the previous step, by including in the sub-table the $r_x = r_b - x$ rows and the $n_x = n_b -x$ columns of the lowest indexes, and replacing with the conventional exponent of the null matrix ($\mathbf{I}_{Z_f}^{[-1]}$) each unforced element relevant to that $x$, excepting the element with coordinates 1, $k_b$ +1.

3. The method of claim 1 or 2, **characterized in that** said forcing at step b) is carried out on the same mother exponent table (Tab.2) for many code-rate $R_x$.

4. The method of claim 1 or 2, **characterized in that** said forcing at step b) is carried out by masking the exponent matrix $\mathbf{H}_{\text{exp-}x}$ for the code-rate $R_x$ with a seed matrix dedicated to that code-rate.

5. The method of any claim from 1 to 4, **characterized in that** bits other than multiple of spreading factor are punctured successively in known way.

6. The method of any claim from 1 to 5, **characterized in that** step c) is complemented by masking the exponent matrix $\mathbf{H}_{\text{exp-}x}$ for the code-rate $R_x$ with a seed matrix dedicated to that code-rate.

7. A system (FIG.1) having means (CH-ENC, CH-DEC) for performing the steps of the method according to any claim from 1 to 6.

FIG. 1

EP 2 285 004 A1

$$\mathbf{I}_{Z_f}^{[0]} = \begin{bmatrix} 0 & 0 & 0 & 0 & \cdots & 0 & 0 & 1 \\ 0 & 0 & 0 & 0 & \cdots & 0 & 1 & 0 \\ 0 & 0 & 0 & 0 & \cdots & 1 & 0 & 0 \\ \cdot & \cdot & \cdot & \cdot & \cdots & \cdot & \cdot & \cdot \\ 0 & 0 & 0 & 1 & \cdots & 0 & 0 & 0 \\ 0 & 0 & 1 & 0 & \cdots & 0 & 0 & 0 \\ 0 & 1 & 0 & 0 & \cdots & 0 & 0 & 0 \\ 1 & 0 & 0 & 0 & \cdots & 0 & 0 & 0 \end{bmatrix}$$

$$\mathbf{I}_{Z_f}^{[Z_f-1]} = \begin{bmatrix} 1 & 0 & 0 & 0 & 0 & \cdots & 0 & 0 \\ 0 & 0 & 0 & 0 & 0 & \cdots & 0 & 1 \\ 0 & 0 & 0 & 0 & 0 & \cdots & 1 & 0 \\ \cdot & \cdot & \cdot & \cdot & \cdot & \cdots & \cdot & \cdot \\ 0 & 0 & 0 & 0 & 1 & \cdots & 0 & 0 \\ 0 & 0 & 0 & 1 & 0 & \cdots & 0 & 0 \\ 0 & 0 & 1 & 0 & 0 & \cdots & 0 & 0 \\ 0 & 1 & 0 & 0 & 0 & \cdots & 0 & 0 \end{bmatrix}$$

$$\mathbf{I}_{Z_f}^{[-1]} = \begin{bmatrix} 0 & 0 & 0 & 0 & \cdots & 0 & 0 & 0 \\ 0 & 0 & 0 & 0 & \cdots & 0 & 0 & 0 \\ 0 & 0 & 0 & 0 & \cdots & 0 & 0 & 0 \\ \cdot & \cdot & \cdot & \cdot & \cdots & \cdot & \cdot & \cdot \\ 0 & 0 & 0 & 0 & \cdots & 0 & 0 & 0 \\ 0 & 0 & 0 & 0 & \cdots & 0 & 0 & 0 \\ 0 & 0 & 0 & 0 & \cdots & 0 & 0 & 0 \\ 0 & 0 & 0 & 0 & \cdots & 0 & 0 & 0 \end{bmatrix}$$

$$\mathbf{I}_{Z_f}^{[1]} = \begin{bmatrix} 0 & 0 & 0 & \cdots & 0 & 0 & 1 & 0 \\ 0 & 0 & 0 & \cdots & 0 & 1 & 0 & 0 \\ 0 & 0 & 0 & \cdots & 1 & 0 & 0 & 0 \\ \cdot & \cdot & \cdot & \cdots & \cdot & \cdot & \cdot & \cdot \\ 0 & 0 & 1 & \cdots & 0 & 0 & 0 & 0 \\ 0 & 1 & 0 & \cdots & 0 & 0 & 0 & 0 \\ 1 & 0 & 0 & \cdots & 0 & 0 & 0 & 0 \\ 0 & 0 & 0 & \cdots & 0 & 0 & 0 & 1 \end{bmatrix}$$

FIG. 2

| r\c | 1 | 2 | 3 | i | 72 | 73 | 74 | 75 | 76 | 77 | 78 | 79 | i | 87 | 88 | 89 | 90 | 91 | 92 | 93 | 94 | 95 | 96 |
|---|---|---|---|---|---|---|---|---|---|---|---|---|---|---|---|---|---|---|---|---|---|---|---|
| 1 | 33 | 36 | 39 | | 28 | 31 | 0 | -1 | -1 | -1 | -1 | -1 | | -1 | -1 | -1 | -1 | -1 | -1 | -1 | -1 | -1 | -1 |
| 2 | 36 | 42 | 48 | | 26 | 32 | 0 | 0 | -1 | -1 | -1 | -1 | | -1 | -1 | -1 | -1 | -1 | -1 | -1 | -1 | -1 | -1 |
| 3 | 35 | 40 | 45 | | 63 | 68 | -1 | 0 | 0 | -1 | -1 | -1 | | -1 | -1 | -1 | -1 | -1 | -1 | -1 | -1 | -1 | -1 |
| 4 | 38 | 46 | 54 | | 61 | 69 | -1 | -1 | 0 | 0 | -1 | -1 | | -1 | -1 | -1 | -1 | -1 | -1 | -1 | -1 | -1 | -1 |
| 5 | 41 | 52 | 63 | | 59 | 70 | -1 | -1 | -1 | 0 | 0 | -1 | | -1 | -1 | -1 | -1 | -1 | -1 | -1 | -1 | -1 | -1 |
| 6 | 39 | 48 | 57 | | 24 | 33 | -1 | -1 | -1 | -1 | 0 | 0 | | -1 | -1 | -1 | -1 | -1 | -1 | -1 | -1 | -1 | -1 |
| 7 | 43 | 56 | 69 | | 94 | 107 | -1 | -1 | -1 | -1 | -1 | 0 | | -1 | -1 | -1 | -1 | -1 | -1 | -1 | -1 | -1 | -1 |
| 8 | 32 | 34 | 36 | | 65 | 67 | -1 | -1 | -1 | -1 | -1 | -1 | | -1 | -1 | -1 | -1 | -1 | -1 | -1 | -1 | -1 | -1 |
| 9 | 52 | 74 | 96 | | 88 | 1 | -1 | -1 | -1 | -1 | -1 | -1 | | -1 | -1 | -1 | -1 | -1 | -1 | -1 | -1 | -1 | -1 |
| 10 | 49 | 68 | 87 | | 90 | 0 | -1 | -1 | -1 | -1 | -1 | -1 | | -1 | -1 | -1 | -1 | -1 | -1 | -1 | -1 | -1 | -1 |
| 11 | 51 | 72 | 93 | | 16 | 37 | -1 | -1 | -1 | -1 | -1 | -1 | | -1 | -1 | -1 | -1 | -1 | -1 | -1 | -1 | -1 | -1 |
| 12 | 34 | 38 | 42 | | 100 | 104 | -1 | -1 | -1 | -1 | -1 | -1 | | -1 | -1 | -1 | -1 | -1 | -1 | -1 | -1 | -1 | -1 |
| 13 | 50 | 70 | 90 | | 53 | 73 | -1 | -1 | -1 | -1 | -1 | -1 | | -1 | -1 | -1 | -1 | -1 | -1 | -1 | -1 | -1 | -1 |
| 14 | 31 | 32 | 33 | | 102 | 103 | -1 | -1 | -1 | -1 | -1 | -1 | | 0 | -1 | -1 | -1 | -1 | -1 | -1 | -1 | -1 | -1 |
| 15 | 54 | 78 | 102 | | 14 | 38 | -1 | -1 | -1 | -1 | -1 | -1 | | 0 | 0 | -1 | -1 | -1 | -1 | -1 | -1 | -1 | -1 |
| 16 | 46 | 62 | 78 | | 92 | 0 | -1 | -1 | -1 | -1 | -1 | -1 | | -1 | 0 | 0 | -1 | -1 | -1 | -1 | -1 | -1 | -1 |
| 17 | 53 | 76 | 99 | | 51 | 74 | -1 | -1 | -1 | -1 | -1 | -1 | | -1 | -1 | 0 | 0 | -1 | -1 | -1 | -1 | -1 | -1 |
| 18 | 44 | 58 | 72 | | 57 | 71 | -1 | -1 | -1 | -1 | -1 | -1 | | -1 | -1 | -1 | 0 | 0 | -1 | -1 | -1 | -1 | -1 |
| 19 | 37 | 44 | 51 | | 98 | 105 | -1 | -1 | -1 | -1 | -1 | -1 | | -1 | -1 | -1 | -1 | 0 | 0 | -1 | -1 | -1 | -1 |
| 20 | 42 | 54 | 66 | | 22 | 34 | -1 | -1 | -1 | -1 | -1 | -1 | | -1 | -1 | -1 | -1 | -1 | 0 | 0 | -1 | -1 | -1 |
| 21 | 40 | 50 | 60 | | 96 | 106 | -1 | -1 | -1 | -1 | -1 | -1 | | -1 | -1 | -1 | -1 | -1 | -1 | 0 | 0 | -1 | -1 |
| 22 | 47 | 64 | 81 | | 55 | 72 | -1 | -1 | -1 | -1 | -1 | -1 | | -1 | -1 | -1 | -1 | -1 | -1 | -1 | 0 | 0 | -1 |
| 23 | 48 | 66 | 84 | | 18 | 36 | -1 | -1 | -1 | -1 | -1 | -1 | | -1 | -1 | -1 | -1 | -1 | -1 | -1 | -1 | 0 | 0 |
| 24 | 45 | 60 | 75 | | 20 | 35 | -1 | -1 | -1 | -1 | -1 | -1 | | -1 | -1 | -1 | -1 | -1 | -1 | -1 | -1 | -1 | 0 |

FIG. 3 – TABLE 1 (KNOWN ART)

| r\c | 1 | 2 | 3 | i | 72 | 73 | 74 | 75 | 76 | 77 | 78 | 79 | i | 87 | 88 | 89 | 90 | 91 | 92 | 93 | 94 | 95 | 96 |
|---|---|---|---|---|---|---|---|---|---|---|---|---|---|---|---|---|---|---|---|---|---|---|---|
| 1 | 33 | 36 | 39 | | 28 | 31 | 0 | -1 | -1 | -1 | -1 | -1 | | -1 | -1 | -1 | -1 | -1 | -1 | -1 | -1 | -1 | -1 |
| 2 | 36 | 42 | 48 | | 26 | 32 | 0 | 0 | -1 | -1 | -1 | -1 | | -1 | -1 | -1 | -1 | -1 | -1 | -1 | -1 | -1 | -1 |
| 3 | 35 | 40 | 45 | | 63 | 0 | -1 | 0 | 0 | -1 | -1 | -1 | | -1 | -1 | -1 | -1 | -1 | -1 | -1 | -1 | -1 | -1 |
| 4 | 38 | 46 | 54 | | 61 | 69 | -1 | -1 | 0 | 0 | -1 | -1 | | -1 | -1 | -1 | -1 | -1 | -1 | -1 | -1 | -1 | -1 |
| 5 | 41 | 52 | 63 | | 59 | 70 | -1 | -1 | -1 | 0 | 0 | -1 | | -1 | -1 | -1 | -1 | -1 | -1 | -1 | -1 | -1 | -1 |
| 6 | 39 | 48 | 57 | | 24 | 31 | -1 | -1 | -1 | -1 | 0 | 0 | | -1 | -1 | -1 | -1 | -1 | -1 | -1 | -1 | -1 | -1 |
| 7 | 43 | 56 | 69 | | 94 | 107 | -1 | -1 | -1 | -1 | -1 | 0 | | -1 | -1 | -1 | -1 | -1 | -1 | -1 | -1 | -1 | -1 |
| 8 | 32 | 34 | 36 | | 65 | 67 | -1 | -1 | -1 | -1 | -1 | -1 | | -1 | -1 | -1 | -1 | -1 | -1 | -1 | -1 | -1 | -1 |
| 9 | 52 | 74 | 96 | | 88 | 1 | -1 | -1 | -1 | -1 | -1 | -1 | | -1 | -1 | -1 | -1 | -1 | -1 | -1 | -1 | -1 | -1 |
| 10 | 49 | 68 | 87 | | 90 | 0 | -1 | -1 | -1 | -1 | -1 | -1 | | -1 | -1 | -1 | -1 | -1 | -1 | -1 | -1 | -1 | -1 |
| 11 | 51 | 72 | 93 | | 16 | 37 | -1 | -1 | -1 | -1 | -1 | -1 | | -1 | -1 | -1 | -1 | -1 | -1 | -1 | -1 | -1 | -1 |
| 12 | 34 | 38 | 42 | | 100 | 104 | -1 | -1 | -1 | -1 | -1 | -1 | | -1 | -1 | -1 | -1 | -1 | -1 | -1 | -1 | -1 | -1 |
| 13 | 50 | 70 | 90 | | 53 | 73 | -1 | -1 | -1 | -1 | -1 | -1 | | -1 | -1 | -1 | -1 | -1 | -1 | -1 | -1 | -1 | -1 |
| 14 | 31 | 32 | 33 | | 102 | 103 | -1 | -1 | -1 | -1 | -1 | -1 | | 0 | -1 | -1 | -1 | -1 | -1 | -1 | -1 | -1 | -1 |
| 15 | 54 | 78 | 102 | | 14 | 38 | -1 | -1 | -1 | -1 | -1 | -1 | | 0 | 0 | -1 | -1 | -1 | -1 | -1 | -1 | -1 | -1 |
| 16 | 46 | 62 | 78 | | 92 | 31 | -1 | -1 | -1 | -1 | -1 | -1 | | -1 | 0 | 0 | -1 | -1 | -1 | -1 | -1 | -1 | -1 |
| 17 | 53 | 76 | 99 | | 51 | 74 | -1 | -1 | -1 | -1 | -1 | -1 | | -1 | -1 | 0 | 0 | -1 | -1 | -1 | -1 | -1 | -1 |
| 18 | 44 | 58 | 72 | | 57 | 71 | -1 | -1 | -1 | -1 | -1 | -1 | | -1 | -1 | -1 | 0 | 0 | -1 | -1 | -1 | -1 | -1 |
| 19 | 37 | 44 | 51 | | 98 | 105 | -1 | -1 | -1 | -1 | -1 | -1 | | -1 | -1 | -1 | -1 | 0 | 0 | -1 | -1 | -1 | -1 |
| 20 | 42 | 54 | 66 | | 22 | 34 | -1 | -1 | -1 | -1 | -1 | -1 | | -1 | -1 | -1 | -1 | -1 | 0 | 0 | -1 | -1 | -1 |
| 21 | 40 | 50 | 60 | | 96 | 106 | -1 | -1 | -1 | -1 | -1 | -1 | | -1 | -1 | -1 | -1 | -1 | -1 | 0 | 0 | -1 | -1 |
| 22 | 47 | 64 | 81 | | 55 | 72 | -1 | -1 | -1 | -1 | -1 | -1 | | -1 | -1 | -1 | -1 | -1 | -1 | -1 | 0 | 0 | -1 |
| 23 | 48 | 66 | 84 | | 18 | 31 | -1 | -1 | -1 | -1 | -1 | -1 | | -1 | -1 | -1 | -1 | -1 | -1 | -1 | -1 | 0 | 0 |
| 24 | 45 | 60 | 75 | | 20 | 31 | -1 | -1 | -1 | -1 | -1 | -1 | | -1 | -1 | -1 | -1 | -1 | -1 | -1 | -1 | -1 | 0 |

FIG. 4 – TABLE. 2

EP 2 285 004 A1

| r\c | i | 73 | 74 | 75 | 76 | 77 | 78 | 79 | i | 87 | 88 | 89 | 90 | 91 | 92 | 93 | 94 | 95 | 96 |
|---|---|---|---|---|---|---|---|---|---|---|---|---|---|---|---|---|---|---|---|
| 1 | | 31 | 0 | -1 | -1 | -1 | -1 | -1 | | -1 | -1 | -1 | -1 | -1 | -1 | -1 | -1 | -1 | -1 |
| 2 | | -1 | 0 | 0 | -1 | -1 | -1 | -1 | | -1 | -1 | -1 | -1 | -1 | -1 | -1 | -1 | -1 | -1 |
| 3 | | 0 | -1 | 0 | 0 | -1 | -1 | -1 | | -1 | -1 | -1 | -1 | -1 | -1 | -1 | -1 | -1 | -1 |
| 4 | | -1 | -1 | -1 | 0 | 0 | -1 | -1 | | -1 | -1 | -1 | -1 | -1 | -1 | -1 | -1 | -1 | -1 |
| 5 | | -1 | -1 | -1 | -1 | 0 | 0 | -1 | | -1 | -1 | -1 | -1 | -1 | -1 | -1 | -1 | -1 | -1 |
| 6 | | -1 | -1 | -1 | -1 | -1 | 0 | 0 | | -1 | -1 | -1 | -1 | -1 | -1 | -1 | -1 | -1 | -1 |
| 7 | | -1 | -1 | -1 | -1 | -1 | -1 | 0 | | -1 | -1 | -1 | -1 | -1 | -1 | -1 | -1 | -1 | -1 |
| 8 | | -1 | -1 | -1 | -1 | -1 | -1 | -1 | | -1 | -1 | -1 | -1 | -1 | -1 | -1 | -1 | -1 | -1 |
| 9 | | -1 | -1 | -1 | -1 | -1 | -1 | -1 | | -1 | -1 | -1 | -1 | -1 | -1 | -1 | -1 | -1 | -1 |
| 10 | | -1 | -1 | -1 | -1 | -1 | -1 | -1 | | -1 | -1 | -1 | -1 | -1 | -1 | -1 | -1 | -1 | -1 |
| 11 | | -1 | -1 | -1 | -1 | -1 | -1 | -1 | | -1 | -1 | -1 | -1 | -1 | -1 | -1 | -1 | -1 | -1 |
| 12 | | -1 | -1 | -1 | -1 | -1 | -1 | -1 | | -1 | -1 | -1 | -1 | -1 | -1 | -1 | -1 | -1 | -1 |
| 13 | | -1 | -1 | -1 | -1 | -1 | -1 | -1 | | -1 | -1 | -1 | -1 | -1 | -1 | -1 | -1 | -1 | -1 |
| 14 | | -1 | -1 | -1 | -1 | -1 | -1 | -1 | | 0 | -1 | -1 | -1 | -1 | -1 | -1 | -1 | -1 | -1 |
| 15 | | -1 | -1 | -1 | -1 | -1 | -1 | -1 | | 0 | 0 | -1 | -1 | -1 | -1 | -1 | -1 | -1 | -1 |
| 16 | | -1 | -1 | -1 | -1 | -1 | -1 | -1 | | -1 | 0 | 0 | -1 | -1 | -1 | -1 | -1 | -1 | -1 |
| 17 | | -1 | -1 | -1 | -1 | -1 | -1 | -1 | | -1 | -1 | 0 | 0 | -1 | -1 | -1 | -1 | -1 | -1 |
| 18 | | -1 | -1 | -1 | -1 | -1 | -1 | -1 | | -1 | -1 | -1 | 0 | 0 | -1 | -1 | -1 | -1 | -1 |
| 19 | | -1 | -1 | -1 | -1 | -1 | -1 | -1 | | -1 | -1 | -1 | -1 | 0 | 0 | -1 | -1 | -1 | -1 |
| 20 | | -1 | -1 | -1 | -1 | -1 | -1 | -1 | | -1 | -1 | -1 | -1 | -1 | 0 | 0 | -1 | -1 | -1 |
| 21 | | -1 | -1 | -1 | -1 | -1 | -1 | -1 | | -1 | -1 | -1 | -1 | -1 | -1 | 0 | 0 | -1 | -1 |
| 22 | | -1 | -1 | -1 | -1 | -1 | -1 | -1 | | -1 | -1 | -1 | -1 | -1 | -1 | -1 | 0 | 0 | -1 |
| 23 | | -1 | -1 | -1 | -1 | -1 | -1 | -1 | | -1 | -1 | -1 | -1 | -1 | -1 | -1 | -1 | 0 | 0 |
| 24 | | 31 | -1 | -1 | -1 | -1 | -1 | -1 | | -1 | -1 | -1 | -1 | -1 | -1 | -1 | -1 | -1 | 0 |

FIG. 5 - TABLE 3

EP 2 285 004 A1

| r\c | i | 73 | 74 | 75 | 76 | 77 | 78 | 79 | i | 87 | 88 | 89 | 90 | 91 | 92 | 93 | 94 | 95 |
|---|---|---|---|---|---|---|---|---|---|---|---|---|---|---|---|---|---|---|
| 1 | | 31 | 0 | -1 | -1 | -1 | -1 | -1 | | -1 | -1 | -1 | -1 | -1 | -1 | -1 | -1 | -1 |
| 2 | | -1 | 0 | 0 | -1 | -1 | -1 | -1 | | -1 | -1 | -1 | -1 | -1 | -1 | -1 | -1 | -1 |
| 3 | | 0 | -1 | 0 | 0 | -1 | -1 | -1 | | -1 | -1 | -1 | -1 | -1 | -1 | -1 | -1 | -1 |
| 4 | | -1 | -1 | -1 | 0 | 0 | -1 | -1 | | -1 | -1 | -1 | -1 | -1 | -1 | -1 | -1 | -1 |
| 5 | | -1 | -1 | -1 | -1 | 0 | 0 | -1 | | -1 | -1 | -1 | -1 | -1 | -1 | -1 | -1 | -1 |
| 6 | | -1 | -1 | -1 | -1 | -1 | 0 | 0 | | -1 | -1 | -1 | -1 | -1 | -1 | -1 | -1 | -1 |
| 7 | | -1 | -1 | -1 | -1 | -1 | -1 | 0 | | -1 | -1 | -1 | -1 | -1 | -1 | -1 | -1 | -1 |
| 8 | | -1 | -1 | -1 | -1 | -1 | -1 | -1 | | -1 | -1 | -1 | -1 | -1 | -1 | -1 | -1 | -1 |
| 9 | | -1 | -1 | -1 | -1 | -1 | -1 | -1 | | -1 | -1 | -1 | -1 | -1 | -1 | -1 | -1 | -1 |
| 10 | | -1 | -1 | -1 | -1 | -1 | -1 | -1 | | -1 | -1 | -1 | -1 | -1 | -1 | -1 | -1 | -1 |
| 11 | | -1 | -1 | -1 | -1 | -1 | -1 | -1 | | -1 | -1 | -1 | -1 | -1 | -1 | -1 | -1 | -1 |
| 12 | | -1 | -1 | -1 | -1 | -1 | -1 | -1 | | -1 | -1 | -1 | -1 | -1 | -1 | -1 | -1 | -1 |
| 13 | | -1 | -1 | -1 | -1 | -1 | -1 | -1 | | -1 | -1 | -1 | -1 | -1 | -1 | -1 | -1 | -1 |
| 14 | | -1 | -1 | -1 | -1 | -1 | -1 | -1 | | 0 | -1 | -1 | -1 | -1 | -1 | -1 | -1 | -1 |
| 15 | | -1 | -1 | -1 | -1 | -1 | -1 | -1 | | 0 | 0 | -1 | -1 | -1 | -1 | -1 | -1 | -1 |
| 16 | | -1 | -1 | -1 | -1 | -1 | -1 | -1 | | -1 | 0 | 0 | -1 | -1 | -1 | -1 | -1 | -1 |
| 17 | | -1 | -1 | -1 | -1 | -1 | -1 | -1 | | -1 | -1 | 0 | 0 | -1 | -1 | -1 | -1 | -1 |
| 18 | | -1 | -1 | -1 | -1 | -1 | -1 | -1 | | -1 | -1 | -1 | 0 | 0 | -1 | -1 | -1 | -1 |
| 19 | | -1 | -1 | -1 | -1 | -1 | -1 | -1 | | -1 | -1 | -1 | -1 | 0 | 0 | -1 | -1 | -1 |
| 20 | | -1 | -1 | -1 | -1 | -1 | -1 | -1 | | -1 | -1 | -1 | -1 | -1 | 0 | 0 | -1 | -1 |
| 21 | | -1 | -1 | -1 | -1 | -1 | -1 | -1 | | -1 | -1 | -1 | -1 | -1 | -1 | 0 | 0 | -1 |
| 22 | | -1 | -1 | -1 | -1 | -1 | -1 | -1 | | -1 | -1 | -1 | -1 | -1 | -1 | -1 | 0 | 0 |
| 23 | | 31 | -1 | -1 | -1 | -1 | -1 | -1 | | -1 | -1 | -1 | -1 | -1 | -1 | -1 | -1 | 0 |

FIG. 6 - TABLE 4

EP 2 285 004 A1

| r\c | i | 73 | 74 | 75 | 76 | 77 | 78 | 79 | i | 87 | 88 |
|-----|---|----|----|----|----|----|----|----|---|----|----|
| 1 | | 31 | 0 | -1 | -1 | -1 | -1 | -1 | | -1 | -1 |
| 2 | | -1 | 0 | 0 | -1 | -1 | -1 | -1 | | -1 | -1 |
| 3 | | 0 | -1 | 0 | 0 | -1 | -1 | -1 | | -1 | -1 |
| 4 | | -1 | -1 | -1 | 0 | 0 | -1 | -1 | | -1 | -1 |
| 5 | | -1 | -1 | -1 | -1 | 0 | 0 | -1 | | -1 | -1 |
| 6 | | -1 | -1 | -1 | -1 | -1 | 0 | 0 | | -1 | -1 |
| 7 | | -1 | -1 | -1 | -1 | -1 | -1 | 0 | | -1 | -1 |
| 8 | | -1 | -1 | -1 | -1 | -1 | -1 | | | -1 | -1 |
| 9 | | -1 | -1 | -1 | -1 | -1 | -1 | -1 | | -1 | -1 |
| 10 | | -1 | -1 | -1 | -1 | -1 | -1 | -1 | | -1 | -1 |
| 11 | | -1 | -1 | -1 | -1 | -1 | -1 | -1 | | -1 | -1 |
| 12 | | -1 | -1 | -1 | -1 | -1 | -1 | -1 | | -1 | -1 |
| 13 | | -1 | -1 | -1 | -1 | -1 | -1 | -1 | | -1 | -1 |
| 14 | | -1 | -1 | -1 | -1 | -1 | -1 | -1 | | 0 | -1 |
| 15 | | -1 | -1 | -1 | -1 | -1 | -1 | -1 | | 0 | 0 |
| 16 | | 31 | -1 | -1 | -1 | -1 | -1 | -1 | | -1 | 0 |

FIG. 7 - TABLE 5

| r\c | i | 73 | 74 | 75 | 76 | 77 | 78 |
|---|---|---|---|---|---|---|---|
| 1 | | 31 | 0 | -1 | -1 | -1 | -1 |
| 2 | | -1 | 0 | 0 | -1 | -1 | -1 |
| 3 | | 0 | -1 | 0 | 0 | -1 | -1 |
| 4 | | -1 | -1 | -1 | 0 | 0 | -1 |
| 5 | | -1 | -1 | -1 | -1 | 0 | 0 |
| 6 | | 31 | -1 | -1 | -1 | -1 | 0 |

FIG. 8 - TABLE 6

Europäisches
Patentamt

European
Patent Office

Office européen
des brevets

# EUROPEAN SEARCH REPORT

Application Number

EP 09 16 5350

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2008/301518 A1 (MIYAZAKI SHUNJI [JP]) 4 December 2008 (2008-12-04) <br> * figures 4,8,20 * <br> * abstract * <br> * paragraph [0019] - paragraph [0036] * <br> * paragraph [0168] - paragraph [0169] * <br> ----- | 1-7 | INV. H03M13/11 |
| A | US 2007/011569 A1 (VILA CASADO ANDRES I [US] ET AL) 11 January 2007 (2007-01-11) <br> * paragraph [0035] - paragraph [0049] * <br> * paragraph [0059] - paragraph [0075] * <br> ----- | 1-7 | |
| A | ZHICHU LIN ET AL.: "A new design method of multi-rate quasi-cyclic LDPC codes" COMMUNICATIONS, CIRCUITS AND SYSTEMS PROCEEDINGS, 2006 INTERNATIONAL CONFERENCE ON, IEEE, PI, 1 June 2006 (2006-06-01), pages 707-711, XP031010530 ISBN: 978-0-7803-9584-8 <br> * the whole document * <br> ----- | 1-7 | |
| A | SHASHA E ET AL: "Multi-Rate LDPC code for OFDMA PHY" INTERNET CITATION 25 June 2004 (2004-06-25), XP002334837 Retrieved from the Internet: URL:http://www.ieee802.org/16/tge/contrib/ C80216e-04_185.pdf> [retrieved on 2005-07-05] * the whole document * <br> ----- <br> -/-- | 1-7 | TECHNICAL FIELDS SEARCHED (IPC) <br> H03M |

The present search report has been drawn up for all claims

| Place of search | Date of completion of the search | Examiner |
|---|---|---|
| Munich | 9 December 2009 | Offer, Elke |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

**EUROPEAN SEARCH REPORT**

Application Number

EP 09 16 5350

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | JONG-EE OH ET AL: "Row-splitting design of Low-Density Parity-Check codes for Gbps transmission" VEHICULAR TECHNOLOGY CONFERENCE, 2007. VTC-2007 FALL. 2007 IEEE 66TH, IEEE, PI, 1 September 2007 (2007-09-01), pages 1127-1131, XP031147582 ISBN: 978-1-4244-0263-2 * the whole document * ----- | 1-7 | |
| | | | **TECHNICAL FIELDS SEARCHED (IPC)** |

The present search report has been drawn up for all claims

| Place of search | Date of completion of the search | Examiner |
|---|---|---|
| Munich | 9 December 2009 | Offer, Elke |

EPO FORM 1503 03.82 (P04C01)

**ANNEX TO THE EUROPEAN SEARCH REPORT
ON EUROPEAN PATENT APPLICATION NO.**

EP 09 16 5350

This annex lists the patent family members relating to the patent documents cited in the above-mentioned European search report.
The members are as contained in the European Patent Office EDP file on
The European Patent Office is in no way liable for these particulars which are merely given for the purpose of information.

09-12-2009

| Patent document cited in search report | Publication date | Patent family member(s) | Publication date |
|---|---|---|---|
| US 2008301518 A1 | 04-12-2008 | WO 2007091327 A1 | 16-08-2007 |
| US 2007011569 A1 | 11-01-2007 | NONE | |

EPO FORM P0459

For more details about this annex : see Official Journal of the European Patent Office, No. 12/82

**EP 2 285 004 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **Jon G. Proakis.** DIGITAL COMMUNICATIONS. Mc-Graw-Hill, 2001

- **Zaheer ; Zummo ; Landolsi ; Kousa.** Improved regular and semi-random rate-compatible low-density parity-check codes with short block lengths. *IET (Institution Engineering Technology) Communications,* 2008, vol. 2 (7), 960-971